# EUROPEAN PATENT SPECIFICATION

(11) **EP 1 681 321 B1**
(45) Date of publication and mention of the grant of the patent: **10.08.2011**
(21) Application number: 04792849.4
(22) Date of filing: 22.10.2004
(51) Int. Cl.: C09D 11/00, H05K 1/09, H05K 3/10, H05K 3/18

(54) **INKJET INK COMPOSITION**
TINTENZUSAMMENSETZUNG FÜR DEN TINTENSTRAHLDRUCK
COMPOSITION D'ENCRE POUR IMPRESSION A JET D'ENCRE

(30) Priority: 05.11.2003 JP 2003375130
(43) Date of publication of application: 19.07.2006
(73) Proprietor: Nippon Mining & Metals Co., Ltd., Minato-ku Tokyo 105-8407 (JP)
(72) Inventor: KAWAMURA, Toshifumi, c/o Isohara Plant, Kitaibaraki-shi, Ibaraki 3191535 (JP); IMORI, Toru, c/o Isohara Plant, Kitaibaraki-shi, Ibaraki 3191535 (JP)
(74) Representative: Gassenhuber, Andreas
(86) International application number: PCT/JP2004/015707
(87) International publication number: WO 2005/044931

(56) References cited:
- JP-A- 10 317 159
- JP-B2- 3 380 880

## Description

### TECHNICAL FIELD

The present invention relates to an ink composition that is suitable for drawing a wiring pattern on a substrate by inkjet process.

### BACKGROUND ART

A variety of methods have already been proposed to use an inkjet process to draw a wiring pattern on a substrate.

For example, there is a method to form a fine wiring pattern by using an inkjet head to discharge onto a substrate an ink comprising metal microparticles to which a sulfur compound was adsorbed, present in a solvent (Japanese Patent Publication No. H10-204350). Also known is a method to form a pattern of an activator for electroless plating on a substrate by inkjet process. For instance, there has been proposed a method to manufacture a printed wiring board in which an initiator pattern is formed on a substrate by aggregates of dots of a water-based ink discharged by an inkjet printer, these ink dots are dried and the substrate is electroless plated (Japanese Patent Publication No. H7-245467). In this method, the water-based ink is composed of water, a water-soluble organic solvent, and a palladium salt.

The use of a silane coupling agent to improve the adhesion of electroless metal pattern to substrate has already been proposed (Japanese Patent No. 3,380,880). Here, a pattern is drawn with an inkjet printer using a silane coupling agent solution, then the pattern is immersed in an activation solution to make an activator adhere to the drawn pattern, after which the pattern is electroless plated with nickel. Amino-based silane coupling agents such as γ-aminopropyltriethoxysilane are said to be favorable as the above-mentioned silane coupling agent.

### DISCLOSURE OF THE INVENTION

Nevertheless, when an amino-based silane coupling agent such as γ-aminopropyltriethoxysilane is used, the state of capturing (adhesion of) the activator is not uniform, that is, the distribution or concentration of the activator is not uniform. In addition, the adhesive strength is still inadequate, so the underlying surface has to be given a pretreatment such as etching.

It is an object of the present invention to provide an inkjet ink composition to uniformly form a wiring pattern having excellent adhesion on a substrate, and to provide a method to form a wiring pattern by using this ink composition.

As a result of diligent research, the inventors arrived at the present invention upon discovering that it is effective for the ink composition to contain an electroless plating activator along with an azole compound as a coupling agent that captures this activator and adheres to the substrate.

Specifically, the present invention is:
(1) An ink composition for inkjet, for drawing a wiring pattern on a substrate, comprising an azole-based silane coupling agent as a coupling agent for an activator.
(2) The ink composition according to (1) above, wherein the azole-based silane coupling agent is imidazolesilane.
(3) A method for drawing a wiring pattern by inkjet process on a substrate, wherein an ink composition according to (1) above is used.
(4) A method for coating a wiring pattern with a metal, comprising: drawing the wiring pattern by inkjet process on a substrate; immersing the substrate in an activator solution as necessary; and electroless plating the substrate; wherein an ink composition according to Claim 1 is used to draw the wiring pattern.

### BEST MODE FOR CARRYING OUT THE INVENTION

It is important that the ink composition of the present invention contains an azole-based silane coupling agent.

The function of this azole-based silane coupling agent is to allow an electroless plating activator to bond with good adhesion to a substrate, and to securely adhere a film subsequently produced by electroless plating. In the present invention, the activator may be contained in the ink composition, or it may be prepared as a separate solution from the ink composition and a wiring pattern drawn with an ink containing an azole-based silane coupling agent may be immersed in a solution of this activator so that the activator adheres thereto.

Standard additives used in inkjet inks such as viscosity adjusters and surface tension adjusters, can be used as needed in the ink composition of the present invention.

The azole-based silane coupling agent used in the present invention is a compound that contains an azole group and an alkoxysilane group.

Examples of the azole groups include an imidazole group, oxazole group, thiazole group, selenazole group, pyrazole group, isoxazole group, isothiazole group, triazole group, oxadiazole group, thiadiazole group, tetrazole group, oxatriazole group, thiatriazole group, bendazole group, indazole group, benzimidazole group, and benzotriazole group. Of these, an imidazole group is preferred.

The alkoxysilane group may be any group that exhibits a coupling function and is included in standard silane coupling agents, examples of which include silanes having one to three lower alkoxy groups such as methoxy groups or ethoxy groups.

This azole-based.silane coupling agent itself has been known and it can be obtained, for example, by reacting an azole compound such as imidazole with an epoxysilane such as γ-glycidoxypropyltrialkoxysilane. This reaction was discussed, for example, in Japanese Patent Publication No. H5-186479.

The concentration of azole compound is from 0.01 to 100 g/L, and preferably from 0.05 to 5 g/L. If the concentration is less than 0.01 g/L, the amount adhering to the substrate surface will not be uniform because the amount is too little. But, if the concentration is over 100 g/L, the material will take a long time to dry, and cost will be higher because the amount adhering is too much.

The electroless plating activator used in the present invention can be a noble metal compound, examples of which include halides, hydroxides, sulfates, carbonates, fatty acid salts, and other such compounds of platinum, palladium, gold, silver, and so forth. Palladium compounds are particularly favorable. When the ink composition contains this activator, the concentration thereof is preferably from 0.01 to 100 g/L. The same applies when this activator is prepared as a separate solution from the ink composition.

### Examples

### Example 1

The ink composition was prepared as: a palladium chloride aqueous solution was added to an aqueous solution of the equimolar reaction product of imidazole and γ-glycidoxypropyltrimethoxysilane; to the solution, water,
a viscosity adjuster, and a surface tension adjuster were added to contain the above-mentioned equimolar reaction product in an amount of 300 mg/L and the palladium chloride aqueous solution in an amount of 100 mg/L. This ink composition was discharged from an inkjet nozzle to draw a wiring circuit on a substrate. After this, the substrate was electroless nickel plated (Nikom 7N-0, made by Nikko Metal Plating) to a film thickness of 0.2 µm. Over this, it was electroless copper plated (KC500, made by Nikko Metal Plating) to a thickness of 1 µm. A cross section was observed by SEM, which revealed that there was no deposition outside the pattern, and wiring had been formed with a distinct plating boundary. The peel strength of this plating film was 1.5 kgf/cm², which indicates high adhesion.

### Example 2

To prepare the ink composition, water, a viscosity adjuster, and a surface tension adjuster were added to the equimolar reaction product of imidazole and γ-glycidoxypropyltrimethoxysilane to contain the above-mentioned equimolar reaction product in an amount of 300 mg/L. This ink composition was discharged from an inkjet nozzle to draw a wiring circuit on a substrate. Then, this product was immersed in a palladium chloride aqueous solution (100 mg/L) and the palladium was fixed by the imidazole rings. After this, the substrate was electroless nickel plated (Nikom 7N-0, made by Nikko Metal Plating) to a film thickness of 0.2 µm. Over this, it was electroless copper plated (KC500, made by Nikko Metal Plating) to a thickness of 1 µm. A cross section was observed by SEM, which revealed that there was no deposition outside the pattern, and wiring had been formed with a distinct plating boundary. The peel strength of this plating film was 1.5 kgf/cm².

### Comparative Example

Except for using a γ-aminopropyltrimethoxysilane aqueous solution in place of the equimolar reaction product of imidazole and γ-glycidoxypropyltrimethoxysilane, an ink composition was prepared in the same manner as in Example 1, and other than using this ink composition, a wiring pattern was formed and electroless plating was performed in the same manner as in Example 1.

As a result, the peel strength of the plating film was 0.3 kgf/cm².

### INDUSTRIAL APPLICABILITY

With the present invention, by making the ink composition contain an azole compound and by utilizing inkjet process that uses the composition, an electroless plating activator can be provided uniformly with excellent adhesion to a substrate. Therefore, a wiring pattern having excellent adhesion can be obtained by electroless plating on this substrate surface without pretreatment such as roughening.

## Claims

1. An ink composition for inkjet, for a drawing wiring pattern on a substrate, comprising an azole-based silane coupling agent as a coupling agent for an activator.

2. The ink composition according to Claim 1, wherein the azole-based silane coupling agent is imidazolesilane.

3. A method for drawing a wiring pattern by inkjet process on a substrate, wherein an ink composition according to Claim 1 is used.

4. A method for coating a wiring pattern with a metal, comprising: drawing the wiring pattern by inkjet process on a substrate; immersing the substrate in an activator solution as necessary; and electroless plating the substrate; wherein an ink composition according to Claim 1 is used to draw the wiring pattern.

## Patentansprüche

1. Tintenzusammensetzung für Tintenstrahldruck für eine Schaltungs-Zeichenvorlage auf einem Substrat, umfassend ein Silan-Kupplungsmittel auf Azol-Basis als Kupplungsmittel für einen Aktivator.

2. Tintenzusammensetzung gemäß Anspruch 1, wobei das Silan-Kupplungsmittel auf Azol-Basis Imidazolsilan ist.

3. Verfahren zum Zeichnen einer Schaltungsvorlage durch ein Tintenstrahldruckverfahren auf ein Substrat, wobei eine Tintenzusammensetzung gemäß Anspruch 1 verwendet wird.

4. Verfahren zum Beaufschlagen einer Schaltungsvorlage mit einem Metall, umfassend: das Zeichnen der Schaltungsvorlage durch ein Tintenstrahldruckverfahren auf ein Substrat; das Tauchen des Substrats in eine Aktivator-Lösung, falls erforderlich; und das stromlose Metallisieren des Substrats; wobei eine Tintenzusammensetzung gemäß Anspruch 1 zum Zeichnen der Schaltungsvorlage verwendet wird.

## Revendications

1. Composition d'encre pour jet d'encre, pour un motif de câblage dessiné sur un substrat, comprenant un agent de couplage au silane à base d'azole comme agent de couplage pour un activateur.

2. Composition d'encre selon la revendication 1, dans laquelle l'agent de couplage au silane à base d'azole est de l'imidazolesilane.

3. Procédé pour tracer un motif de câblage par un processus à jet d'encre sur un substrat, dans lequel une composition d'encre selon la revendication 1 est utilisée.

4. Procédé pour revêtir un motif de câblage d'un métal, comprenant : le traçage du motif de câblage par un processus à jet d'encre sur un substrat ; l'immersion du substrat dans une solution d'activateur si nécessaire ; et le placage autocatalytique du substrat ; dans lequel une composition d'encre selon la revendication 1 est utilisée pour tracer le motif de câblage.
